# EUROPÄISCHE PATENTSCHRIFT

(11) **EP 0 850 398 B1**
(45) Veröffentlichungstag und Bekanntmachung des Hinweises auf die Patenterteilung: **16.04.2003**
(21) Anmeldenummer: 97932780.6
(22) Anmeldetag: 08.07.1997
(51) Int. Cl.: G01D 5/245

(54) **VERFAHREN ZUR POSITIONSBESTIMMUNG UND HIERZU GEEIGNETES MESSSYSTEM**
PROCESS FOR LOCATING, AND MEASURING SYSTEM SUITABLE THEREFOR
PROCEDE DE DETERMINATION DE POSITION ET SYSTEME DE MESURE POUR LA MISE EN OEUVRE DE CE PROCEDE

(30) Priorität: 10.07.1996 DE 19627670; 25.09.1996 DE 19639315
(43) Veröffentlichungstag der Anmeldung: 01.07.1998
(73) Patentinhaber: Dr. Johannes Heidenhain GmbH, 83292 Traunreut (DE)
(72) Erfinder: HAGL, Rainer, D-83352 Altenmarkt (DE); BIELSKI, Steffen, D-84518 Garching (DE); HUBER, Helmut, D-84518 Garching (DE)
(86) Internationale Anmeldenummer: EP9703596
(87) Internationale Veröffentlichungsnummer: WO98001724

(56) Entgegenhaltungen:
- DE-C- 19 513 692
- POLAK: "drehgeber oder resolver" ELEKTRONIK., Bd. 44, Nr. 25, 12.Dezember 1995, MUNCHEN DE, Seiten 60-64, XP000550385

## Beschreibung

Die vorliegende Erfindung betrifft ein Verfahren zur Positionsbestimmung sowie ein hierzu geeignetes Meßsystem. Insbesondere geeignet sind das erfindungsgemäße Verfahren sowie das erfindungsgemäße Meßsystem zur Bestimmung der Position eines rotierenden Antriebsteiles.

Zur präzisen Steuerung eines elektrischen Antriebes ist es erforderlich, die Position des umlaufenden Rotors stets hochgenau zu erfassen und insbesondere bei Synchronmotoren bereits ab dem Start einer Rotationsbewegung die absolute Rotorposition zu kennen. Hierzu sind verschiedenste rotatorische Meßsysteme bekannt, die die erfaßten Positions-Meßwerte jeweils über mehrere Verbindungsleitungen an eine nachgeordnete Auswerteeinheit bzw. Folgeelektronik übertragen. Die Auswerteeinheit wiederum übernimmt die Antriebsansteuerung sowie ggf. weitere Steuerungsfunktionen. Hinsichtlich der dabei eingesetzten Meßsysteme ist ein möglichst geringer Aufwand erwünscht.
Bei der Verwendung hochgenauer absoluter Meßsysteme, die evtl. auch Inkrementaldaten liefern oder aber bei inkrementalen Meßsystemen, welche auch absolute Kommutierungssignale liefern, deren Daten an die Auswerteeinheit übergeben werden, resultieren jedoch relativ aufwendige Systeme; insbesondere bedingt die parallele Übertragung der absoluten und inkrementalen Positionsdaten sowie ggf. der Referenzmarkensignale eine große Anzahl an Verbindungsleitungen.

Zur Reduzierung der Anzahl erforderlicher Verbindungsleitungen zwischen den jeweiligen Meßsystemen und der nachgeordneten Auswerteeinheit ist etwa die Übertragung der Meßwerte und anderer Daten im Multiplex-Betrieb über möglichst wenige Signalverbindungen bekannt.

Aus der EP 0 738 879 A1, die hinsichtlich der vorliegenden Erfindung nur unter Art. 54 (3) EPÜ relevant. ist, ist femer ein Drehwinkelmeßsystem bekannt, welches einen Prozeßdatenkanal sowie einen Parameterkanal besitzt. Der Prozeßdatenkanal, über den die Übertragung der interessierenden Positionsdaten an die nachgeordnete Steuereinheit erfolgt, ist jedoch als analoger Prozeßdatenkanal ausgebildet.

Die DE 42 20 502 C1 offenbart desweiteren ein Drehwinkelmeßsystem, welches neben einer analogen Übertragung von inkrementalen Positionsdaten ferner eine digitale Übertragung von absoluten Positionsdaten an eine Auswerteelektronik vorsieht. Die Druckschrift enthält jedoch keine Hinweise bzgl. einer möglichst sicheren Erzeugung und Übertragung der absoluten Positionsdaten.

Aufgabe der vorliegenden Erfindung ist es, ein Verfahren zur Positionsbestimmung, insbesondere zur Erfassung von Drehbewegungen eines rotierenden Antriebsteiles sowie ein hierzu geeignetes Meßsystem zu schaffen, bei dem ein möglichst geringer Aufwand resultiert. Insbesondere wünschenswert ist hierbei ein reduzierter Aufwand hinsichtlich der erforderlichen Signal-Übertragungsleitungen zwischen dem Meßsystem und der nachgeordneten Auswerteeinheit. Desweiteren soll auch eine hinreichend präzise und sichere Positionserfassung möglichst bald nach dem Anlaufen des rotierenden Antriebsteiles gewährleistet sein.

Diese Aufgabe wird gelöst durch ein Verfahren mit den Merkmalen des Anspruches 1.
Vorteilhafte Ausführungsformen des erfindungsgemäßen Verfahrens ergeben sich aus den Maßnahmen in den abhängigen Ansprüchen.

Ein geeignetes Meßsystem zur Lösung der angesprochenen Problematik ist Gegenstand des Anspruches 18.
Mögliche Maßnahmen zur vorteilhaften Ausgestaltung des erfindungsgemäßen Meßsystemes sind in den abhängigen Ansprüchen angegeben.

Das erfindungsgemäße Meßsystem bzw. das erfindungsgemäße Verfahren bietet nunmehr die Möglichkeit zur Erfassung der Absolutposition eines rotierenden Antriebsteiles zu jedem Zeitpunkt der Rotationsbewegung. Zu Beginn der Rotationsbewegung ist eine Steuerung des Antriebes, d.h. insbesondere die nötige Antriebskommutierung, auf Grundlage der an die Auswerteeinheit übertragenen Positionsdaten ebenfalls bereits mit hinreichender Präzision möglich. Hierbei basieren die in digitaler Form übertragenen Positionsdaten auf den Positionsdaten des eingesetzten absoluten Teil-Meßsystems, d.h. die Auflösung der zu diesem Zeitpunkt für die Antriebskommutierung übertragenen Positionsdaten hängt von der zur Verfügung stehenden Auflösung des absoluten Teil-Meßsystems ab. Sobald das erste Mal eine Referenzmarkierung passiert wird, deren absolute Position bekannt ist, steht in Verbindung mit den Meßwerten des inkrementalen Teil-Meßsystemes ein hochgenauer, absoluter Positionsmeßwert für den nachfolgenden Betrieb des Antriebes bzw. dessen Ansteuerung zur Verfügung, der an die Auswerteeinheit übertragen wird. Hierbei existieren verschiedene Möglichkeiten für die Herstellung des Absolutbezuges, d.h. insbesondere hinsichtlich der Verwendung von ein oder mehreren Referenzmarken.

Darüberhinaus ergibt sich die gewünschte Reduzierung der erforderlichen Verbindungsleitungen zwischen dem eigentlichen Meßsystem und der nachgeordneten Auswerteeinheit, da keine parallele Übertragung der Positionsdaten des absoluten und des inkrementalen Teil-Meßsystems sowie der Referenzmarkierungssignale zur Auswerteeinheit erforderlich ist. Die Erzeugung absoluter Positionsdaten erfolgt mit der hinreichenden Genauigkeit für die verschiedenen Betriebsphasen des rotierenden Antriebsteiles bereits auf Meßsystem-Seite; über eine serielle Schnittstelleneinheit werden die absoluten Positionsdaten in digitaler Form an die Auswerteeinheit übertragen.

Das erfindungsgemäße Verfahren sowie das erfindungsgemäße Meßsystem können desweiteren in vorteilhafter Weise derart weitergebildet werden, daß eine Reihe von sicherheitsrelevanten Überwachungsmaßnahmen vorgesehen werden. So ist es etwa möglich, an die Auswerteeinheit Signale zu übertragen, die die Abweichung der mit geringerer Auflösung bestimmten Positionsdaten in der Anlaufphase von den tatsächlichen Positionsdaten charakterisieren.

Desweiteren können auch nach der Herstellung des Absolutbezuges Signale an die Auswerteeinheit übertragen werden, die eine laufende Überwachung der mit höherer Genauigkeit bestimmten absoluten Positionsdaten ermöglichen etc..

Weitere Vorteile sowie Einzelheiten des erfindungsgemäßen Verfahrens und des erfindungsgemäßen Meßsystems ergeben sich aus der nachfolgenden Beschreibung eines Ausführungsbeispiels anhand der beiliegenden Zeichnungen.

Dabei zeigt
- Figur 1: eine schematische Darstellung eines Ausführungsbeispiels des erfindungsgemäßen Meßsystems;
- Figur 2: eine Darstellung eines Ausführungsbeispieles von an die Auswerteeinheit übertragenen Datenblöcken.

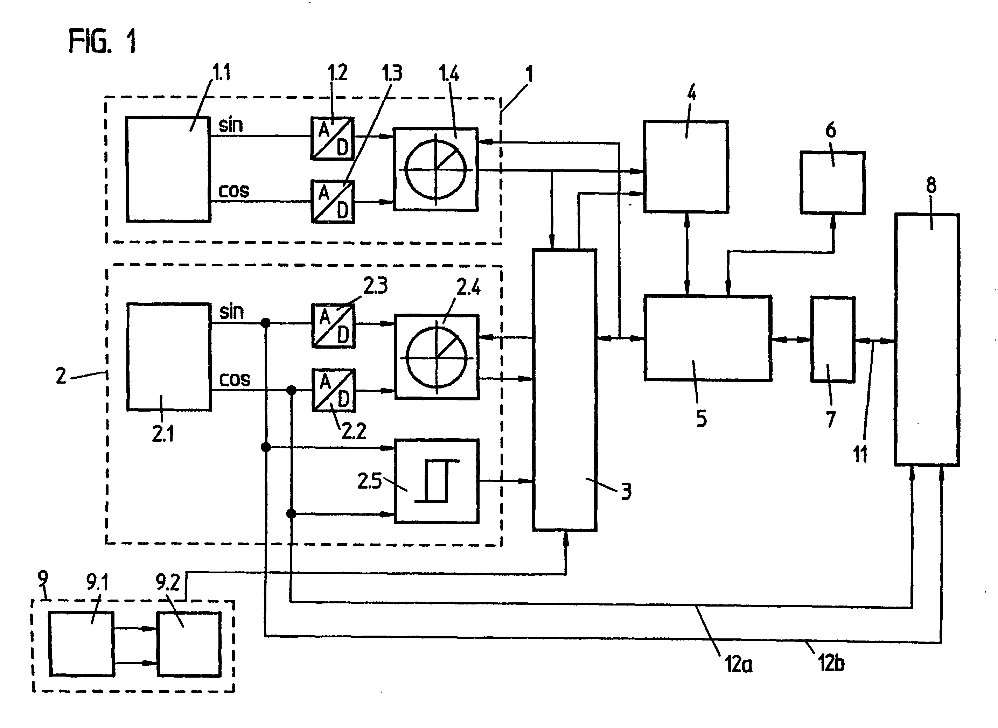

Das in Figur 1 schematisch dargestellte Ausführungsbeispiel des erfindungsgemäßen Meßsystems umfaßt zwei Teil-Meßsysteme (1, 2), von denen eines als inkrementales Teil-Meßsystem (2) ausgebildet ist, während das andere als absolutes Teil-Meßsystem (1) ausgebildet ist, das die laufende Erfassung der Absolutposition des - nicht dargestellten - rotierenden Antriebsteiles, ermöglicht. Nachfolgend sei hierbei auch vom Rotor die Rede. Erfindungsgemäß ist zu diesem Zweck kein hochpräzises absolutes Meßsystem erforderlich, es genügt vielmehr ein Teil-Meßsystem (1), das innerhalb einer Umdrehung des rotierenden Antriebsteiles eine grobe absolute Positionsbestimmung ermöglicht. Beispielsweise kann zu diesem Zweck eine Genauigkeit der Positionsbestimmung auf etwa 5° ausreichen, wobei sich die erforderliche Genauigkeit dieses Teil-Meßsystemes (1) nach dem jeweils eingesetzten Antrieb richtet. Das verwendete absolute Teil-Meßsystem (1) muß zumindest eine Auflösung besitzen, die die Kommutierung des Antriebes gestattet. Im Fall einer sogenannten Blockkommutierung ist demnach sicherzustellen, daß eine absolute Positionsbestimmung innerhalb der drei 120°-Segmente des Drehstromfeldes möglich ist.
Ein hierfür geeignetes, absolutes Teil-Meßsystem (1) kann etwa als Meßsystem mit einer sogenannten Kommutierungsspur ausgebildet sein, wie sie bei Antriebs-Drehgebern bekannt ist. Dieses Teil-Meßsystem (1) erlaubt die Bestimmung der Rotor-Absolutposition auf Grundlage der sinus- und cosinusförmigen Abtastsignale (sin, cos). Die entsprechenden Abtastsignale (sin, cos) weisen hierbei jeweils eine Signalperiode auf, die einer Umdrehung des rotierenden Antriebsteiles entspricht, so daß über eine Rotor-Umdrehung eine absolute Positionsbestimmung eindeutig möglich ist.

Zur Weiterverarbeitung und Absolutpositionsbestimmung liegen bei einem derart ausgebildeten Teil-Meßsystem (1) sinus- bzw. cosinusförmige Abtastsignale (sin, cos) vor, die über A/D-Wandlereinheiten (1.2, 1.3) digitalisiert werden; anschließend erfolgt in einer weiteren Verarbeitungsstufe (1.4) dieses Teil-Meßsystems (1) die Bildung der absoluten Positionsmeßwerte in bekannter Art und Weise, z.B. durch die Bestimmung des arctan aus den beiden Abtastsignalen (sin, cos). Zur Erzeugung der sinus- bzw. cosinusförmigen Abtastignale (sin, cos) umfaßt die Meßanordnung (1.1) in einer möglichen Ausführungsform u.a. eine Abtasteinheit, mit der photoelektrisch eine Teilungsspur abgetastet wird.

Alternativ kann hierzu, je nach gewünschter bzw. erforderlicher Genauigkeit, auch ein absolutes Teil-Meßsystem (1) eingesetzt werden, bei dem die Bestimmung der Absolutposition z.B. auf Grundlage der photoelektrischen Abtastung ein oder mehrerer Codespuren erfolgt etc., d.h. das absolute Teil-Meßsystem (1) kann in vielfältiger Art und Weise ausgebildet sein. Entscheidend für die Auswahl des absoluten Teil-Meßsystems (1) ist lediglich, daß die Auflösung des jeweiligen absoluten Teil-Meßsystems (1) zumindest für die Antriebskommutierung ausreicht.

Das desweiteren vorgesehene inkrementale Teil-Meßsystem (2) ist in bekannter Art und Weise ausgebildet und liefert ausgangsseitig Positionssignale, die inkrementalen Meßschritten entsprechen. Hierzu werden die sinus- und cosinusförmigen Abtastsignale (sin, cos), die z.B. durch die photoelektrische Abtastung einer Teilscheibe in einer Meßanordnung (2.1) erzeugt werden, über A/D-Wandlereinheiten (2.2, 2.3) digitalisiert und einer Verarbeitungsstufe (2.4) dieses Teil-Meßsystems (2) zugeführt, in der eine Interpolation bzw. Unterteilung der Inkrementalsignale erfolgt. Pro Signalperiode werden die Inkrementalsignale in dieser Verarbeitungsstufe (2.4) demzufolge in eine vorbestimmte Anzahl von Meßschritten unterteilt.

Innerhalb des erfindungsgemäßen Meßsystems kann im übrigen auch eine wählbare Interpolationsrate des inkrementalen Teil-Meßsystemes (2) durch den Anwender ebenso vorgesehen werden wie eine definiert wählbare Einstellung der Auflösungsschritte des absoluten Teil-Meßsystemes (1). Derart läßt sich beispielsweise ein universell ausgelegtes Gesamtsystem vom Anwender an verschiedene Anforderungen respektive Antriebskonfigurationen anpassen.

In der dargestellten Ausführungsform des erfindungsgemäßen Meßsystems ist eine weitere, zweite Verarbeitungsstufe (2.5) vorgesehen, die dem inkrementalen Teil-Meßsystem (2) zugeordnet ist. Über diese Verarbeitungsstufe (2.5) ist eine Vierfach-Unterteilung der Signalperiode der analogen Abtastsignale (sin, cos) möglich, d.h. über die Verarbeitungsstufe (2.5) steht die grobe Positionsinformation innerhalb einer Signalperiode der Inkrementalsignale zur Verfügung. In Verbindung mit den interpolierten Signalen der anderen Verarbeitungsstufe (2.4) kann somit innerhalb einer Signalperiode der Inkrementalsignale die Position des rotierenden Antriebsteiles präzise bestimmt werden.
Die Ausgangssignale der beiden Verarbeitungsstufen (2.4, 2.5) werden hierzu jeweils an eine nachgeordnete Positionsbestimmungseinheit (3) zur Weiterverarbeitung übergeben, deren Funktion nachfolgend noch näher erläutert wird.

Femer sind in der dargestellten Ausführungsform der erfindungsgemäßen Vorrichtung in der Darstellung zwei Signalleitungen (12a, 12b) erkennbar, über die die analogen Inkrementalsignale (sin, cos) des inkrementalen Teil-Meßsystems (2) desweiteren direkt der nachgeordneten Auswerteeinheit (8) zugeführt werden. Dort können die analogen Inkremental-Signale (sin, cos) ausgewertet werden, um etwa die Geschwindigkeit der Relativbewegung der zwei zueinander beweglichen Teile zu bestimmen. Desweiteren erweist sich die Übertragung der Inkrementalsignale dann vorteilhaft, wenn auf Seiten der Auswerteeinheit eine hohe Regelungsdynamik erforderlich ist. Grundsätzlich ist eine zusätzliche Übertragung der analogen Inkremental-Signale in der erfindungsmäßen Vorrichtung jedoch nicht erforderlich.

Ferner umfaßt das erfindungsgemäße Meßsystem eine lediglich schematisch angedeutete Einrichtung (9) zur Erzeugung von Referenz-Signalen bzw. Referenz-Impulsen an Referenzmarkierungen, welche an bekannten Absolutpositionen angeordnet sind. Hierbei können ein oder mehrere Referenzmarken über eine Umdrehung des Antriebsteiles vorgesehen werden, die jeweils die eindeutige Herstellung eines Absolutbezuges ermöglichen. Verschiedene mögliche Varianten zur Anordnung von Referenzmarken innerhalb einer Umdrehung des rotierenden Antriebsteiles werden nachfolgend noch näher erläutert.
Die Einrichtung (9) zur Erzeugung von Referenz-Signalen umfaßt hierbei eine Meßanordnung (9.1), die z.B. zur photoelektrischen Abtastung einer Referenz-Teilungsspur geeignet ist. Die Ausgangssignale der Meßanordnung (9.1) werden einer Verarbeitungsstufe (9.2) zugeführt, die die Signale in einer Form aufbereitet, die die Übermittlung an die Positionsbestimmungseinheit (3) gestattet.

Wie bereits oben angedeutet, werden daneben auch die positionsabhängigen Signale des inkrementalen (2) und des absoluten (1) Teil-Meßsystems an die Positionsbestimmungseinheit (3) übergeben. Die Ausgangssignale des absoluten Teil-Meßsystems (1) sowie der Positionsbestimmungseinheit (3) werden zusätzlich auf eine Vergleichereinheit (4) durchgeschaltet. Zu den Funktionen dieser Komponenten (3, 4) innerhalb des erfindungsgemäßen Meßsystemes sowie der desweiteren vorgesehenen Ablaufsteuerung (5), der Speichereinheit (6) und der seriellen Schnittstelleneinheit (7) sei auf die nachfolgende Beschreibung eines Ausführungsbeispieles des erfindungsgemäßen Verfahrens verwiesen.

So erfolgt zu Meßbeginn, d.h. sobald sich der Rotor des Antriebes zu drehen beginnt, die Bestimmung eines absoluten Positionsmeßwertes als Startposition mit Hilfe des absoluten Teil-Meßsystemes (1). Nachfolgend wird die absolute Position des Rotors bestimmt, indem mit der ermittelten absoluten Startposition die laufend erzeugten Meßwerte des inkrementalen Teil-Meßsystems (2) verrechnet werden. Üblicherweise geschieht dies durch die Addition der inkrementalen Meßschritte zur bekannten absoluten Startposition. Diese Verfahrensschritte erfolgen mit Hilfe der Positionsbestimmungseinheit (3), der hierzu die erfaßten Meßwerte des inkrementalen und absoluten Teil-Meßsystems (1, 2) zugeführt werden.
Die absolute Position des Rotors ist in diesem ersten Drehungsabschnitt dabei mit der Genauigkeit der Bestimmung der absoluten Startposition behaftet, d.h. von der Genauigkeit des absoluten Teil-Meßsystemes (1) abhängig. Das absolute Teil-Meßsystem ermöglicht etwa eine absolute Positionsbestimmung mit einer Genauigkeit von ca. 5°, was für die Kommutierung des Antriebes ausreicht.
Die in der Positionsbestimmungseinheit (3) derart ermittelten, absoluten Positionsmeßwerte des umlaufenden Rotors werden über die serielle Schnittstelleneinheit (7) sowie eine geeignete Signalübertragungsleitung (11) in digitaler Form laufend an die nachgeordnete Auswerteeinheit (8) übergeben, wo die Signal-Weiterverarbeitung erfolgt.

Die Bestimmung der Absolutposition erfolgt in dieser Art und Weise und mit der entsprechenden Genauigkeit solange, bis bei der Rotordrehung das erste Mal eine Referenzmarkierung erreicht wird, deren Absolutposition exakt bekannt ist bzw. im Fall abstandscodierter Referenzmarkierungen entsprechend zwei Referenzmarkierungen überfahren wurden. Sobald ein entsprechendes Referenzmarkierungssignal an die Positionsbestimmungseinheit (3) übertragen wird, ist die exakte Position des Rotors genauer als im ersten Drehungsabschnitt bestimmbar, d.h. genauer als mit der Auflösung des absoluten Teil-Meßsystems. Die Referenzmarkierung wird ab diesem Zeitpunkt in der Positionsbestimmungsienheit (3) als bekannte absolute Bezugsposition für das inkrementale Teil-Meßsystem (2) verwendet, d.h. die inkrementalen Positionsdaten mit der absoluten Bezugsposition der Referenzmarkierung verrechnet. Die Ausgabe der Positionsdaten über die serielle Schnittstelleneinheit (7) an die Auswerteeinheit (8) ist ab diesem Zeitpunkt somit gleichbedeutend mit der Kenntnis der exakten Absolutposition des Rotors.

Im Hinblick auf die Herstellung des korrekten Absolutbezuges mit Hilfe von Referenzmarkierungen existieren dabei verschiedene Möglichkeiten. So kann wie bislang beschrieben lediglich eine einzige Referenzmarkierung pro Umdrehung des rotierenden Antriebsteiles auf Seiten des Meßsystems vorgesehen sein. Die Absolutposition dieser einzelnen Referenzmarkierung ist bekannt. Dies kann im ungünstigsten Fall zur Folge haben, daß fast eine gesamte Umdrehung des Rotors erforderlich ist, bis der korrekte Absolutbezug herstellbar ist.
Um möglichst rasch den gewünschten, exakten Absolutbezug herzustellen, kann deshalb vorgesehen werden mehrere Referenzmarkierungen pro Umdrehung anzuordnen. So muß dann lediglich ein Bruchteil einer Gesamtumdrehung überfahren werden, bis der korrekte Absolutbezug bekannt ist. Bei der Verwendung von mehreren Referenzmarkierungen pro Umdrehung ergeben sich wiederum diverse Möglichkeiten.
So können in einer ersten Ausführungsform sogenannte abstandscodierte Referenzmarkierungen herangezogen werden, wie sie beispielsweise aus der DE 24 16 212 bekannt sind. Dabei weisen benachbart angeordnete Referenzmarkierungen definierte und unterschiedliche Abstände zueinander auf. Aus der Bestimmung der jeweiligen Abstände, beispielsweise durch Zählen der Meßschritte des inkrementalen Teil-Meßsystems (2), kann der eindeutige Absolutbezug nach dem Überfahren zweier Referenzmarkierungen rasch und definiert hergestellt werden, wobei lediglich ein Bruchteil einer Umdrehung des Rotors nötig ist.
In einer zweiten Ausführungsform des erfindungsmäßen Meßsystems mit mehreren Referenzmarkierungen pro Umdrehung ist vorgesehen, mehrere gleichbeabstandete Referenzmarkierungen in einer Referenz-Teilungsspur anzuordnen. Die Zuordnung einer überfahrenen Referenzmarkierung zu einer definierten Absolutposition erfordert in dieser Ausführungsform desweiteren die gleichzeitige Erfasssung eines groben Absolutsignales. Ein derartiges grobes Absolutsignal steht über das grob auflösende, bereits erwähnte absolute Teil-Meßsystem zur Verfügung. Auf Grundlage der beim Überfahren einer einzelnen Referenzmarkierung bekannten groben Positionsinformation kann in Verbindung mit der bekannten Absolutlage der vorhandenen Referenzmarkierungen die jeweils überfahrene Referenzmarkierung bestimmt werden. Dies wiederum bedeutet, daß der exakte Absolutbezug hergestellt ist, ohne daß eine Komplett-Umdrehung des Rotors erforderlich ist.

Die beschriebenen Varianten zur Herstellung des Absolutbezuges können allesamt in Verbindung mit dem erfindungsgemäßen Meßsystem eingesetzt werden.

Beim Erreichen der Referenzmarkierung bzw. der Herstellung des korrekten Absolutbezuges wird der bislang ermittelte absolute Positionsmeßwert mit der tatsächlichen bekannten absoluten Bezugsposition der Referenzmarkierung verglichen, die ggf. vorliegende Abweichung bestimmt und der absolute Positionswert korrigiert. Die Korrektur des bis dato verwendeten absoluten Positionsmeßwertes an der Referenzmarkierung kann auf verschiedene Arten erfolgen.
So wird etwa in einer ersten möglichen Ausführungsform ab dem Erreichen der Referenzmarkierung der bekannte Positionswert der Referenzmarke als Absolutbezug für die Inkrementalsignale verwendet. An die Auswerteeinheit kann dabei zusätzlich zu den absoluten Positionsdaten auch die ermittelte Differenz bzw. Abweichung zwischen der gemessenen und tatsächlichen Absolutposition an der Referenzmarkierung übertragen werden. Ein entsprechendes Differenzsignal wird auf Seiten des Meßsystems mit Hilfe der Vergleichereinheit (4) gebildet, der u.a. die absoluten Positionsdaten der Positionsbestimmungseinheit (3) als auch die Meßwerte des absoluten Teil-Meßsystems (1) zugeführt werden. Im Fall eines großen resultierenden Differenzsignales waren die bisher erfaßten Positionsmeßwerte demzufolge relativ ungenau; ein lediglich kleines Differenzsignal deutet an, daß die bislang erfaßten Positionsmeßwerte relativ exakt bestimmt wurden. Auf Seiten der Auswerteeinheit kann mit Hilfe des übertragenen Differenzsignales dann die Kommutierung des Antriebes schrittweise über mehrere Abtastzyklen korrigiert werden. Derart soll ein ruckweises Bewegen des Rotors bei der Umschaltung auf die korrekte Positionsbestimmung möglichst vermieden werden.

In einer weiteren Ausführungsform kann vorgesehen werden, beim Erreichen der Referenzmarkierung bzw. beim Herstellen des Absolutbezuges und einer festgestellten Abweichung der bislang gemessenen Absolutposition von der tatsächlichen Absolutposiiton den absoluten Positionsmeßwert über die Positionsbestimmungseinheit (3) schrittweise zu korrigieren und an die Auswerteeinheit (8) zu übergeben. Auch dadurch kann bei einer eventuellen großen Abweichung ein ruckweises Bewegen des Antriebes an dieser Stelle vermieden werden.

Ab dem Zeitpunkt des erstmaligen Erreichens einer oder ggf. mehrerer Referenzmarkierungen kann die exakte Absolutposition von der Positionsbestimmungseinheit (3) mit der Genauigkeit des inkrementalen Teil-Meßsystems (2) bestimmt werden. Die entsprechende Ermittlung der absoluten Positionsmeßwerte erfolgt anschließend wie im vorhergehenden Drehungsabschnitt über die Positionsbestimmungseinheit (3), die die bekannte Referenzmarkenposition mit den Positionsmeßwerten des inkrementalen Teil-Meßsystems (2) verrechnet und den absoluten Positionsmeßwert laufend in digitaler Form bestimmt. Über die Schnittstelleneinheit (7) erfolgt wiederum die Übertragung der digitalen, absoluten Positionsdaten an die Auswerteeinheit (8).

Alternativ zur beschriebenen Abfolge der einzelnen Verfahrensschritte ist es grundsätzlich möglich, zu Beginn der Messung auf die Bestimmung einer Startposition und die nachfolgende Verrechnung der inkrementalen Meßsignale mit dieser Startposition zu verzichten. In einer derartigen Ausgestaltung des erfindungsgemäßen Verfahrens wird bis zum ersten Passieren einer Referenzmarkierung die Absolutposition mit Hilfe der Positionsbestimmungseinheit (3) unmittelbar über die Meßwerte des absoluten Teil-Meßsystems (1) bestimmt. Dies erfolgt dann ebenfalls lediglich mit der Genauigkeit des relativ grob auflösenden absoluten Teil-Meßsystems (1). Ab dem Zeitpunkt des erstmaligen Passierens der Referenzmarkierung wird die exakte Position des Rotors in der vorab erläuterten Art und Weise ermittelt, d.h. durch die Verrechnung der bekannten Referenzmarkenposition mit den Positionsmeßwerten des inkrementalen Teil-Meßsystems (2). Ab dem Erreichen der ersten Referenzmarkierung kann die absolute Positionsbestimmung demzufolge ebenfalls mit der zur Verfügung stehenden Genauigkeit des inkrementalen Teilmeßsystems (2) erfolgen.

In einer vorteilhaften Ausführungsform des erfindungsgemäßen Verfahrens bzw. der erfindungsgemäßen Vorrichtung ist zusätzlich vorgesehen, auch nach dem erstmaligem Passieren der Referenzmarkierung bzw. der Herstellung eines exakten Absolutbezuges für die Inkrementalmessung anschließend weiterhin über das absolute Teil-Meßsystem (1) laufend die Position des Rotors zu bestimmen und an die vorgesehene Vergleichereinheit (4) zu übergeben. Ferner empfängt die Vergleichereinheit (4) auch die Ausgangssignale der Positionsbestimmungseinheit (3), d.h. die nach Herstellung des Absolutbezuges erzeugten absoluten Positionsmeßwerte. Innerhalb der Vergleichereinheit (4) wird während des Meßbetriebs laufend die Differenz aus den auf verschiedene Art und Weise erzeugten absoluten Positionsmeßwerten bestimmt, um derart die Positionsmessung zu überwachen. Das entsprechende Differenzsignal kann neben den absoluten Positionsdaten laufend vom Meßsystem über die serielle Schnittstelleneinheit (7) an die Auswerteeinheit (8) übertragen werden. Auf diese Art und Weise ist auf Seiten der Auswerteeinheit (8) eine laufende Überwachung der hochgenauen absoluten Positionsdaten möglich. Der redundante Aufbau ermöglicht den Verzicht auf zusätzliche, weitere Sicherheitseinrichtungen.

Eine weitere bzw. zusätzliche Möglichkeit zur Überwachung der absoluten Positionsbestimmung auf Seiten der Auswerteeinheit (8) besteht darin, die zwischen aufeinanderfolgenden Referenzmarkierungen bestimmten inkrementalen Meßschritte zu erfassen und mit der bekannten, erforderlichen Anzahl derartiger Meßschritte zu vergleichen.
Über die beiden skizzierten Überwachungs- bzw. Vergleichsoperationen ist somit je nach den gegebenen Sicherheitsanforderungen gewährleistet, daß bei einem eventuellen Fehlerfall rasch reagiert werden kann, beispielsweise in Form eines NOT-AUS-Befehles der Auswerteeinheit an den Antrieb etc..

Wie bereits oben angedeutet, erfolgt stets eine Übertragung der digitalen, absoluten Positionsdaten über die serielle Schnittstelleneinheit (7) an die nachgeordnete Auswerteeinheit (8). Während bis zum ersten Passieren einer Referenzmarkierung bei der Absolutpositionsbestimmung die Auflösung des absoluten Teil-Meßsystems (1) zur Verfügung steht, kann nach der erfolgten Herstellung des exakten Absolutbezuges die höhere Genauigkeit bzw. Auflösung des inkrementalen Teil-Meßsystems (2) ausgenutzt werden. Eine Parallelübertragung der positionsbezogenen Daten von absolutem und inkrementalem Teil-Meßsystem sowie der Referenzmarkensignale ist nicht erforderlich, d.h. es ergibt sich eine entsprechende Einsparung an Verbindungsleitungen zwischen dem Meßsystem und der Auswerteeinheit (8).

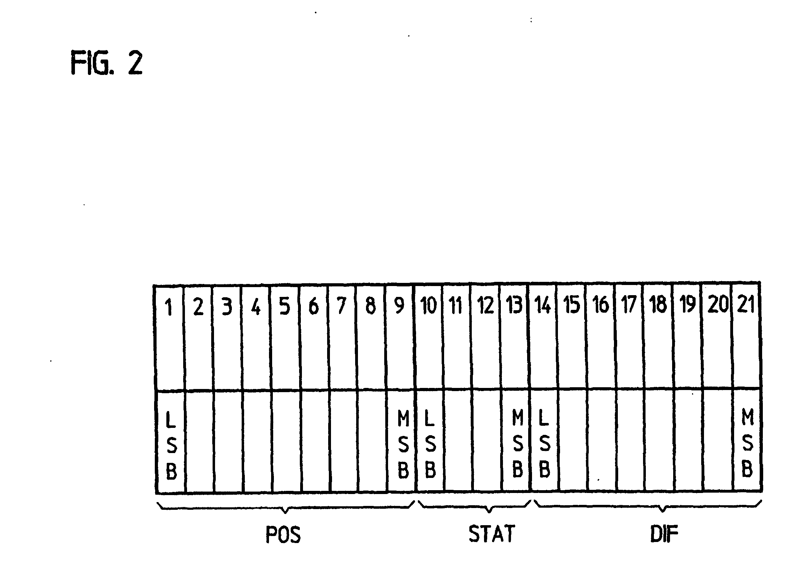

Die Datenübertragung zwischen dem Meßsystem und der Auswerteeinheit (8) erfolgt hierbei vorzugsweise blockweise, wobei verschiedene Daten-Blöcke für die absoluten Positionsdaten, die gebildeten Differenzsignale aus den Positionsmessungen der beiden Teil-Meßsysteme (1, 2) und weitere auf Seiten der Auswerteeinheit (8) interessierende Größen vorgesehen sind. In Figur 2 ist dargestellt, wie etwa die serielle Übertragung derartiger Datenblöcke organisiert werden kann.
So ist ein erster Datenblock POS mit 9 Bits vorgesehen, über den die absolute Positionsinformation in digitaler Form übertragen wird. Ein weiterer Datenblock STAT mit Bits entält die codierte Information, ob bereits eine Referenzmarkierung überfahren wurde. Auswerteseitig steht damit die Information zur Verfügung, mit welcher Auflösung die aktuell übertragenen Positionsdaten erzeugt wurden. Desweiteren ist ein dritter Datenblock DIF mit 8 Bits vorgesehen, über den ein Differenzsignal vom Meßsystem in digitaler Form an die Auswerteeinheit (8) übertragen wird, das auf Seiten des Meßsystems wie oben erläutert erzeugt wurde.
Der gesamte beschriebene Ablauf wird innerhalb des erfindungsgemäßen Meßsystems über die vorgesehene Ablaufsteuerung (5) synchronisiert bzw. gesteuert. Hierzu kann etwa eine CPU oder eine festverdrahtete Schaltung vorgesehen werden, die dem Meßsystem zugeordnet ist.

Das erfindungsgemäße Meßsystem umfaßt desweiteren eine beschreib- und auslesbare Speichereinheit (6), in der meßsystemspezifische Parameter abgelegt werden können. Diese Parameter können etwa beim Meßbeginn an die Auswerteeinheit (8) übergeben und bei der Auswertung genutzt werden usw.. Hinsichtlich weiterer Details sei in diesem Zusammenhang beispielsweise auf die DE 43 42 377 verwiesen.

Das beschriebene Ausführungsbeispiel der vorliegenden Erfindung kann selbstverständlich in vielfacher Form abgewandelt werden, um ggf. an modifizierte Meßanforderungen angepaßt zu werden. Beispielsweise ist es möglich, das beschriebene Meßsystem zu einem sog. Multiturn-Meßsystem auszubauen, indem geeignete Mittel zur Erfassung der Umdrehungen der rotierenden Welle des Rotors zusätzlich vorgesehen werden usw..

## Patentansprüche

1. Verfahren zur Positionsbestimmung, insbesondere eines rotierenden Antriebsteiles, mit Hilfe eines Meßsystemes, welches ein absolutes und ein inkrementales Teil-Meßsystem (1, 2) umfaßt, wobei
- nach dem Meßbeginn der absolute Positionsmeßwert des beweglichen Teiles bestimmt wird,
- wobei die nach dem Meßbeginn bestimmten absoluten Positionsmeßwerte laufend in digitaler Form an eine nachgeordnete Auswerteeinheit (8) übertragen werden bis eine Referenzmarkierung an einer bekannten absoluten Bezugsposition erreicht ist,
- anschließend der aktuell bestimmte absolute Positionsmeßwert mit der bekannten absoluten Bezugsposition verglichen und bei Nicht-Übereinstimmung zumindest teilweise korrigiert wird und daraufhin
- laufend die absoluten Positionsmeßwerte über die Verrechnung der bekannten Referenzmarkenposition mit den Daten des inkrementalen Teil-Meßsystems (2) gebildet werden und in digitaler Form als Ausgangssignal an die nachgeordnete Auswerteeinheit (8) übertragen werden.

2. Verfahren nach Anspruch 1, wobei die absoluten Positionsmeßwerte nach dem Meßbeginn bis zum Erreichen einer Referenzmarkierung durch Verrechnen eines über das absolute Teil-Meßsystem bestimmten absoluten Positionsmeßwertes mit den Positionsmeßwerten des inkrementalen Teil-Meßsystems (2) gebildet werden.

3. Verfahren nach Anspruch 1, wobei die absoluten Positionsmeßwerte nach dem Meßbeginn bis zum Erreichen einer Referenzmarkierung über das absolute Teil-Meßsystem gebildet werden.

4. Verfahren nach Anspruch 1, wobei die Bestimmung der Absolutposition über das absolute Teil-Meßsystem (1) mit Hilfe von sinus- oder cosinusförmigen Abtastsignalen erfolgt, die eine Periodenlänge aufweisen, welche einer Umdrehung des rotierenden Teiles entspricht.

5. Verfahren nach Anspruch 1, wobei die Bestimmung der Absolutposition über das absolute Teil-Meßsystem (1) auf Grundlage der Abtastung einer oder mehrerer Codespuren erfolgt.

6. Verfahren nach Anspruch 1, wobei nach dem erstmaligem Passieren der Referenzmarkierung ein Differenzsignal bezüglich der Differenz der bekannten absoluten Referenzmarkenposition und dem aktuell bestimmten absoluten Positionsmeßwert aus den beiden Teil-Meßsystemen (1, 2) gebildet wird.

7. Verfahren nach Anspruch 6, wobei neben dem absoluten Positionsmeßwert auch das gebildete Differenzsignal in digitaler Form an die Auswerteeinheit (8) übertragen wird.

8. Verfahren nach Anspruch 7, wobei ein blockweiser, serieller Datentransfer zwischen dem Meßsystem und der nachgeordneten Auswerteeinheit (8) erfolgt.

9. Verfahren nach Anspruch 8, wobei einzelne Datenblöcke für die Positionsmeßwerte und für die Differenzsignale an die Auswerteeinheit (8) übertragen werden.

10. Verfahren nach Anspruch 9, wobei desweiteren Datenblöcke bezüglich des Status des absoluten und/oder des inkrementalen Teil-Meßsystems (1, 2) an die Auswerteeinheit (8) übertragen werden.

11. Verfahren nach Anspruch 10, wobei ein Datenblock Statusinformationen diesbezüglich enthält, ob bereits eine Referenzmarkierung überfahren wurde.

12. Verfahren nach Anspruch 6, wobei sämtliche Verfahrensschritte im Zusammenhang mit der Positionsbestimmung und der Differenzsignalbildung auf Seiten des Meßsystems erfolgen und sowohl die absoluten Positions-Meßwerte als auch das Differenz-Signal seriell an eine nachgeordnete Auswerteeinheit (8) übergeben werden.

13. Verfahren nach Anspruch 6, wobei auch nach dem erstmaligen Bestimmen eines absoluten Positionsmeßwertes über das absolute Teil-Meßsystem (1) weiterhin laufend die absolute Position mit Hilfe des absoluten Teil-Meßsystems bestimmt wird.

14. Verfahren nach Anspruch 13, wobei die mit Hilfe des absoluten Teil-Meßsystems (1) erfaßten Positionsmeßwerte laufend mit den absoluten Positionsmeßwerten verglichen werden, die mit Hilfe des inkrementalen Teil-Meßsystems (2) bestimmt werden und ein weiteres Differenzsignal bezüglich einer eventuellen Differenz der voneinander abweichenden Positionsmeßwerte gebildet wird.

15. Verfahren nach Anspruch 1, wobei eine Überprüfung des inkrementalen Teil-Meßsystems (2) erfolgt, indem die Anzahl von inkrementalen Meßschritten zwischen dem Passieren zweier Referenzmarkierungen erfaßt und mit der bekannten Anzahl von Inkrementen verglichen wird, die innerhalb dieses Bereiches liegen müssen.

16. Verfahren nach Anspruch 1, wobei zur Herstellung eines exakten Absolutbezuges mehrere Referenzmarkierungen mit definierten und unterschiedlichen Abständen herangezogen werden.

17. Verfahren nach Anspruch 1, wobei zur Herstellung eines exakten Absolutbezuges mehrere gleichbeabstandete Referenzmarkierungen in Verbindung mit den laufend erfaßten Positionsmeßwerten des absoluten Teil-Meßsystems herangezogen werden.

18. Meßsystem zur Positionsbestimmung, insbesondere eines rotierenden Antriebsteiles, mit
- einem absoluten und einem inkrementalen Teil-Meßsystem (1, 2),
- einer Einrichtung (9) zur Erzeugung von Referenz-Signalen an Referenzmarkierungen mit bekannter Absolutposition,
- einer Positionbestimmungseinheit (3) zur laufenden Bestimmung der Absolutposition des rotierenden Antriebsteiles auf Grundlage der Meßwerte des inkrementalen Teil-Meßsystems (2) in Verbindung mit den Meßwerten des absoluten Teil-Meßsystems (1) und/oder der Meßwerte der Einrichtung (9) zur Erzeugung von Referenzsignalen, wobei die bestimmte Absolutposition in digitaler Form ausgangsseitig zur Verfügung steht,
- einer Vergleichereinheit (4), der die Meßwerte des absoluten Teil-Meßsystems (1) sowie die über die Positionsbestimmungseinheit (3) bestimmte Absolutposition zuführbar sind, um an einer Referenzmarkierung einen Vergleich zwischen dem aktuell bestimmten Positionsmeßwert mit der bekannten absoluten Bezugsposition durchzuführen und bei Nicht-Übereinstimmung zumindest teilweise zu korrigieren,
- eine Schnittstelleneinheit (7), die die Ausgangssignale der Positionbestimmungseinheit (3) in serieller Form an eine nachgeordnete Auswerteeinheit (8) übergibt.

19. Meßsystem nach Anspruch 18, wobei das absolute Teil-Meßsystem (1) derart ausgebildet ist, daß die Bestimmung der Absolutposition auf Grundlage von sinus- oder cosinusförmigen Abtastsignalen erfolgt, die eine Periodenlänge aufweisen, welche einer Umdrehung eines rotierenden Antriebsteiles entspricht.

20. Meßsystem nach Anspruch 18, wobei das absolute Teil-Meßsystem (1) derart ausgebildet ist, daß die Bestimmung der Absolutposition auf Grundlage der Abtastung einer oder mehrerer Codespuren erfolgt.

21. Meßsystem nach Anspruch 18, wobei über die Vergleichereinheit (4) ein Differenzsignal bezüglich einer eventuellen Differenz zwischen der über die Teil-Meßsysteme (1, 2) ermittelten Position und der tatsächlichen Position erzeugbar ist.

22. Meßsystem nach Anspruch 18, wobei auf Seiten des Meßsystems ferner eine Ablaufsteuerungseinheit (5) angeordnet ist, die den Datentransfer innerhalb des Meßsystems sowie zwischen dem Meßsystem und der Auswerteeinheit (8) steuert.

23. Meßsystem nach Anspruch 18, wobei auf Seiten des Meßsystems ferner eine beschreib- und auslesbare Speichereinheit (6) für meßsystemspezifische Parameter angeordnet ist,

24. Meßsystem nach Anspruch 18, wobei die Einrichtung zur Erzeugung von Referenz-Signalen mehrere Referenzmarkierungen mit definierten und unterschiedlichen Abständen zur Herstellung eines exakten Absolütbezuges umfaßt.

25. Meßsystem nach Anspruch 18, wobei die Einrichtung zur Erzeugung von Referenz-Signalen mehrere gleichbeabstandete Referenzmarkierungen umfaßt, die in Verbindung mit den laufend erfaßten Positionsmeßwerten des absoluten Teil-Meßsystems auswertbar sind.

## Claims

1. Method for position determination, in particular of a rotating drive part, by means of a measuring system which comprises an absolute and an incremental part measuring system (1, 2),
- after commencement of measuring, the absolute position measuring value of the movable part being determined,
- the absolute position measuring values which are determined after commencement of measuring being transmitted continuously in digital form to a subsequently disposed evaluation unit (8) until a reference marking is achieved at a known absolute reference position,
- the currently determined absolute position measuring value being next compared with the known absolute reference position and in the case of non-correspondence being at least partially corrected and thereupon
- the absolute position measuring values being continuously formed by calculating the known reference mark position with the data of the incremental part measuring system (2) and being transmitted in digital form as output signal to the subsequently disposed evaluation unit (8).

2. Method according to claim 1, the absolute position measuring values being formed after commencement of measuring up till a reference marking is achieved by calculating an absolute position measuring value, determined via the absolute part measuring system, with the position measuring values of the incremental part measuring system (2).

3. Method according to claim 1, the absolute position measuring values being formed after commencement of measuring up till a reference marking is achieved via the absolute part measuring system.

4. Method according to claim 1, the determination of the absolute position being effected via the absolute part measuring system (1) by means of sine- or cosine-shaped scanning signals, which have a period length which corresponds to one rotation of the rotating part.

5. Method according to claim 1, the determination of the absolute position being effected via the absolute part measuring system (1) on the basis of the scanning of one or more code tracks.

6. Method according to claim 1, a difference signal being formed after the first passing of the reference marking regarding the difference of the known absolute reference mark position and the currently determined absolute position measuring value from the two part measuring systems (1, 2).

7. Method according to claim 6, the formed difference signal also being transmitted in digital form to the evaluation unit (8) in addition to the absolute position measuring value.

8. Method according to claim 7, a block by block serial data transfer being effected between the measuring system and the subsequently disposed evaluation unit (8).

9. Method according to claim 8, individual data blocks for the position measuring values and for the difference signals being transmitted to the evaluation unit (8).

10. Method according to claim 9, data blocks regarding the status of the absolute and/or of the incremental part measuring system (1, 2) being furthermore transmitted to the evaluation unit (8).

11. Method according to claim 10, one data block containing status information regarding whether a reference marking has been passed.

12. Method according to claim 6, all the method steps being effected in connection with the position determination and the difference signal formation on the part of the measuring system and both the absolute position measuring values and the difference signal being delivered serially to a subsequently disposed evaluation unit (8).

13. Method according to claim 6, the absolute position being furthermore continuously determined by means of the absolute part measuring system after the first determination of an absolute position measuring value via the absolute part measuring system (1).

14. Method according to claim 13, the position measuring values detected by means of the absolute part measuring system (1) being continuously compared with the absolute position measuring values which are determined by means of the incremental part measuring system (2) and a further difference signal being formed regarding a possible difference of the position measuring values which deviate from each other.

15. Method according to claim 1, a checking of the incremental part measuring system (2) being effected by detecting the number of incremental measuring steps between the passing of two reference markings and by comparison with the known number of increments which must lie within this range.

16. Method according to claim 1, a plurality of reference markings with defined and different spacings being used in order to produce an exact absolute reference.

17. Method according to claim 1, a plurality of equally-spaced reference markings in conjunction with the continuously detected position measuring values of the absolute part measuring system being used in order to produce an exact absolute reference.

18. Measuring system for position determination, in particular of a rotating drive part, having
- an absolute and an incremental part measuring system (1, 2),
- a device (9) for producing reference signals at reference markings with a known absolute position,
- a position determining unit (3) for continuous determination of the absolute position of the rotating drive part on the basis of the measuring values of the incremental part measuring system (2) in conjunction with the measuring values of the absolute part measuring system (1) and/or of the measuring values of the device (9) for producing reference signals, the determined absolute position being available on the output side in digital form,
- a comparison unit (4) to which the measuring values of the absolute part measuring system (1) and the absolute position which is determined via the position determining unit (3) can be supplied, in order to make a comparison of the currently determined position measuring value with the known absolute reference position at a reference marking, and for at least partial correction in the case of non-correspondence,
- an interface unit (7) which delivers the output signals of the position determining unit (3) in serial form to a subsequently disposed evaluation unit (8).

19. Measuring system according to claim 18, the absolute part measuring system (1) being configured in such a manner that the determination of the absolute position is effected on the basis of sine- or cosine-shaped scanning signals, which have a period length which corresponds to one rotation of a rotating drive part.

20. Measuring system according to claim 18, the absolute part measuring system (1) being configured in such a manner that the determination of the absolute position is effected on the basis of the scanning of one or more code tracks.

21. Measuring system according to claim 18, a difference signal regarding a possible difference between the position detected via the part measuring systems (1, 2) and the actual position being able to be produced via the comparison unit (4).

22. Measuring system according to claim 18, a sequence control unit (5) being furthermore disposed on the part of the measuring system which unit controls the data transfer within the measuring system and between the measuring system and the evaluation unit (8).

23. Measuring system according to claim 18, a write-to and read-out memory unit (6) for parameters which are specific for the measuring system being furthermore disposed on the part of the measuring system.

24. Measuring system according to claim 18, the device for producing reference signals comprising a plurality of reference markings with defined and different spacings in order to produce an exact absolute reference.

25. Measuring system according to claim 18, the device for producing reference signals comprising a plurality of equally-spaced reference markings, which can be evaluated in conjunction with the continuously detected position measuring values of the absolute part measuring system.

## Revendications

1. Procédé de détermination de position, notamment d'un élément d'entraînement tournant, à l'aide d'un système de mesure comprenant un sous-système de mesure absolu (1) et un sous-système de mesure incrémental (2), selon lequel
- après le début de la mesure, la valeur de mesure de position absolue de l'élément mobile est déterminée,
- les valeurs de mesure de position absolues, déterminées après le début de la mesure, étant transmises en continu sous une forme numérique à une unité d'exploitation (8) branchée à la suite, jusqu'à ce qu'un repère de référence situé au niveau d'une position de référence absolue connue soit atteint,
- la valeur de mesure de position absolue, actuellement déterminée, est comparée avec la position de référence absolue connue et, en cas de non-coïncidence, est corrigée au moins partiellement, et ensuite
- les valeurs de mesure de position absolues sont formées en continu, par la prise en compte de la position de repère de référence connue avec les données du sous-système de mesure incrémental (2), et sont transmises sous une forme numérique, en tant que signal de sortie, à l'unité d'exploitation (8) branchée à la suite.

2. Procédé selon la revendication 1, selon lequel les valeurs de mesure de position absolues, après le début de la mesure et jusqu'à ce qu'un repère de référence soit atteint, sont formées par prise en compte d'une valeur de mesure de position absolue, déterminée par le sous-système de mesure absolu, avec les valeurs de mesure de position du sous-système de mesure incrémental (2).

3. Procédé selon la revendication 1, selon lequel, après le début de la mesure et jusqu'à ce qu'un repère de référence soit atteint, les valeurs de mesure de position absolues sont établies par le sous-système de mesure absolu.

4. Procédé selon la revendication 1, selon lequel la détermination de la position absolue s'effectue par l'intermédiaire du sous-système de mesure absolu (1), à l'aide de signaux de palpage sinus ou cosinus, lesquels présentent une longueur de période qui correspond à une révolution de l'élément tournant.

5. Procédé selon la revendication 1, selon lequel la détermination de la position absolue s'effectue par l'intermédiaire du sous-système de mesure absolu (1), sur la base du palpage d'une ou plusieurs piste(s) à code.

6. Procédé selon la revendication 1, selon lequel, après le premier passage sur le repère de référence, un signal différentiel est formé concernant la différence entre la position de repère de référence absolue connue et la valeur de mesure de position absolue, actuellement déterminée, à partir des deux sous-systèmes de mesure (1, 2).

7. Procédé selon la revendication 6, selon lequel, outre la valeur de mesure de position absolue, le signal différentiel formé est également transmis sous une forme numérique à l'unité d'exploitation (8).

8. Procédé selon la revendication 8, selon lequel un transfert de données en série est effectué, par blocs, entre le système de mesure et l'unité d'exploitation (8) branchée à la suite.

9. Procédé selon la revendication 8, selon lequel des blocs de données individuels pour les valeurs de mesure de position et pour les signaux différentiels sont transmis à l'unité d'exploitation (8).

10. Procédé selon la revendication 9, selon lequel des blocs de données concernant l'état du sous-système de mesure absolu et/ou incrémental (1, 2) sont en outre transmis à l'unité d'exploitation (8).

11. Procédé selon la revendication 10, selon lequel un bloc de données contient des informations d'état indiquant si un repère de référence a déjà été balayé.

12. Procédé selon la revendication 6, selon lequel toutes les étapes dudit procédé sont exécutées en relation avec la détermination de position et la formation de signal différentiel, côté système de mesure, et aussi bien les valeurs de mesure de position absolues que le signal différentiel sont transmis en série à une unité d'exploitation (8) branchée à la suite.

13. Procédé selon la revendication 6, selon lequel, même après la première détermination d'une valeur de mesure de position absolue par le sous-système de mesure absolu (1), la position absolue est déterminée en continu à l'aide dudit sous-système de mesure absolu.

14. Procédé selon la revendication 13, selon lequel les valeurs de mesure de position, déterminées à l'aide du sous-système de mesure absolu (1), sont comparées en continu avec les valeurs de mesure de position absolues, qui sont déterminées à l'aide du sous-système de mesure incrémental (2), et un signal différentiel supplémentaire est formé concernant une différence éventuelle entre ces valeurs de mesure de position.

15. Procédé selon la revendication 1, selon lequel on contrôle le sous-système de mesure incrémental (2), en comptant le nombre de pas de mesure incrémentaux entre le passage sur deux repères de référence et en le comparant au nombre connu d'incréments qui doivent se situer à l'intérieur de cette zone.

16. Procédé selon la revendication 1, selon lequel, pour établir une relation absolue exacte, on utilise plusieurs repères de référence présentant des distances définies et différentes.

17. Procédé selon la revendication 1, selon lequel, pour établir une relation absolue exacte, on utilise plusieurs repères de référence équidistants, en relation avec les valeurs de mesure de position déterminées en continu par le sous-système de mesure absolu.

18. Système de mesure pour déterminer la position, notamment d'un élément d'entraînement tournant, comprenant
- un sous-système de mesure absolu (1) et un sous-système de mesure incrémental (2),
- un dispositif (9) pour produire des signaux de référence au niveau de repères de référence ayant une position absolue connue,
- une unité de détermination de position (3) pour déterminer en continu la position absolue de l'élément d'entraînement tournant, sur la base des valeurs de mesure du sous-système de mesure incrémental (2), en relation avec les valeurs de mesure du sous-système de mesure absolu (1), et/ou sur la base des valeurs de mesure du dispositif (9) de génération de signaux de référence, la position absolue déterminée étant disponible sous une forme numérique à la sortie,
- une unité comparateur (4) qui peut recevoir les valeurs de mesure du sous-système de mesure absolu (1) ainsi que la position absolue déterminée par l'unité de détermination de position (3), afin d'effectuer, au niveau d'un repère de référence, une comparaison entre la valeur de mesure de position actuellement déterminée et la position de référence absolue connue et, en cas de non-coïncidence, de procéder à une correction au moins partielle,
- une unité interface (7) qui transmet les signaux de sortie de l'unité de détermination de position (3) en série à une unité d'exploitation (8) branchée à la suite.

19. Système de mesure selon la revendication 18, dans lequel le sous-système de mesure absolu (1) est agencé de manière telle que la détermination de la position absolue s'effectue sur la base de signaux de palpage sinus ou cosinus, lesquels présentent une longueur de période qui correspond à une révolution d'un élément d'entraînement tournant.

20. Système de mesure selon la revendication 18, dans lequel le sous-système de mesure absolu (1) est agencé de manière telle que la détermination de la position absolue s'effectue sur la base du palpage d'une ou de plusieurs piste(s) à code.

21. Système de mesure selon la revendication 18, dans lequel l'unité comparateur (4) permet de produire un signal différentiel concernant une différence éventuelle entre la position déterminée par les sous-systèmes de mesure (1, 2) et la position réelle.

22. Système de mesure selon la revendication 18, dans lequel il est en outre prévu, côté système de mesure, une unité de commande séquentielle (5) qui commande le transfert de données à l'intérieur du système de mesure ainsi qu'entre le système de mesure et l'unité d'exploitation (8).

23. Système de mesure selon la revendication 18, dans lequel il est en outre prévu, côté système de mesure, une unité de mémoire (6) pour des paramètres spécifiques des systèmes de mesure, qui peut recevoir des inscriptions et peut être lue.

24. Système de mesure selon la revendication 18, dans lequel le dispositif pour produire des signaux de référence comprend plusieurs repères de référence présentant des distances définies et différentes, en vue d'établir une relation absolue exacte.

25. Système de mesure selon la revendication 18, dans lequel le dispositif pour produire des signaux de référence comprend plusieurs repères de référence équidistants qui peuvent être exploités en relation avec les valeurs de mesure de position déterminées en continu par le sous-système de mesure absolu.
